# EUROPEAN PATENT APPLICATION

(11) **EP 4 693 382 A1**
(43) Date of publication of application: **11.02.2026**
(21) Application number: 24778109.9
(22) Date of filing: 28.03.2024
(51) Int. Cl.: H01L 21/67, C23C 16/513

(54) **REACTION CHAMBER OF SEMICONDUCTOR PROCESS DEVICE, AND SEMICONDUCTOR PROCESS DEVICE**

(30) Priority: 29.03.2023 CN 202310327639
(71) Applicant: Beijing NAURA Microelectronics Equipment Co., Ltd., Beijing 100176 (CN)
(72) Inventor: LI, Miaomiao, Beijing 100176 (CN); YANG, Laibao, Beijing 100176 (CN); MA, Yuhu, Beijing 100176 (CN)
(74) Representative: LifeTech IP Spies & Behrndt Patentanwälte PartG mbB
(86) International application number: PCT/CN2024/084288
(87) International publication number: WO 2024/199323

(57) **Abstract**

The present disclosure provides a reaction chamber of semiconductor processing equipment and semiconductor processing equipment, relating to the technical field of semiconductor manufacturing equipment, and is designed to address the problem of easily damaged sealing rings in existing reaction chamber sealing structures. The reaction chamber of the semiconductor processing equipment includes a process tube, a sealing flange, and a sealing ring. The outer wall of the process tube is provided with an annular protrusion, the surface of the annular protrusion near the opening of the process tube being coplanar with the radial plane where the opening lies; the sealing flange is provided on one side of the annular protrusion near the opening, the sealing ring surrounds the opening and is pressed between the sealing flange and the annular protrusion; the sealing flange and the process tube are relatively fixedly arranged. The present disclosure makes the sealing ring of the reaction chamber sealing structure less susceptible to damage.

## Description

### FIELD OF THE TECHNOLOGY

The present disclosure relates to, but is not limited to, the technical field of semiconductor manufacturing equipment, and in particular, to a reaction chamber of a semiconductor processing equipment and semiconductor processing equipment.

### BACKGROUND

With the rapid development of the photovoltaic industry, device requirements are becoming increasingly stringent. As the efficiency of silicon wafers produced using the Passivated Emitter Rear Cell (PERC) process has reached its limit, manufacturers have recently begun deploying Tunnel Oxide Passive Contact (TOPCon) production lines. The TOPCon process places very high temperature demands on the device, particularly the diffusion furnace and oxidation annealing furnace. This has a certain impact on the sealing structure of the device used in process steps such as diffusion, annealing, oxidation, and coating.

Currently, the reaction chamber sealing structure of the TOPCon process route typically consists of a flange and an O-ring. This sealing structure offers the advantages of good sealing performance, high reaction chamber consistency, and ease of wafer loading and unloading and device commissioning. However, due to the high temperature requirements of the device, for example, the maximum process temperature of a diffusion furnace can reach over 1000°C, and the direct contact of the sealing ring with the outer wall of the process tube can lead to overheating and subsequent damage to the sealing ring.

### SUMMARY

The first objective of the present disclosure is to provide a reaction chamber for semiconductor processing equipment to address the technical problem of easily damaged sealing rings in existing reaction chamber sealing structures.

The reaction chamber for semiconductor processing equipment provided herein includes a process tube, a sealing flange, and a sealing ring. The outer wall of the process tube is provided with an annular protrusion, located at the end of the outer wall near the opening of the process tube. The sealing flange is provided on a side of the annular protrusion near the opening, and the sealing ring surrounds the opening and is pressed between the sealing flange and the annular protrusion. The sealing flange and the process tube are fixed relative to each other.

The present disclosure further includes a fixed flange and a limiting support. The fixed flange is fitted over the process tube and is located on the side of the annular protrusion facing away from the opening. The fixed flange is fixedly connected to the frame of the semiconductor processing equipment to support the process tube. The sealing flange is fixedly connected to the fixed flange. The limiting support is located between the sealing flange and the fixed flange and is used to separate the sealing flange from the fixed flange by a set distance, the set distance being greater than the thickness of the annular protrusion.

Furthermore, the limiting support is annular and is disposed around the annular protrusion.

Furthermore, the inner surface of the limiting support and the outer surface of the annular protrusion are spaced apart to form a heat dissipation channel. The limiting support is provided with heat dissipation holes, which connect the heat dissipation channel to the external environment.

Furthermore, the limiting support includes a buffering gasket, which is located between the sealing flange and the annular protrusion and is used to provide a buffering gap between the sealing flange and the annular protrusion.

Furthermore, in the radial direction of the process tube, the buffering gasket is closer to the axis of the process tube than the sealing ring.

Furthermore, the reaction chamber further includes a reflective screen, which is disposed around the inner circumference of the process tube, and whose orthographic projection on the inner circumference of the process tube covers the area where the sealing ring is located.

Furthermore, the sealing flange is provided with an annular step, which is disposed around the axis of the process tube and protrudes radially from the inner surface of the sealing flange.

One end of the reflective screen is embedded in the process tube, and the other end of the reflective screen abuts the annular step.

Furthermore, the distance between the outer circumference of the reflective screen and the inner circumference of the process tube is a, where 2 mm≤a≤3 mm.

Furthermore, the sealing flange is provided with a first flow channel, which is arranged around the axis of the process tube and is used to flow a cooling fluid.

Furthermore, a buffering ring is provided, which surrounds the process tube and is pressed between the fixed flange and the annular protrusion.

Furthermore, the fixed flange is provided with a second flow channel, which is arranged around the axis of the process tube and is used to flow a cooling fluid.

Furthermore, the process tube includes a body section and an opening section arranged axially along the process tube. The opening section is made of a non-transparent material, and the annular protrusion is located at the end of the opening section near the opening.

Furthermore, the outer wall of the process tube partially extends away from its axis to form the annular protrusion.

The reaction chamber of the semiconductor processing equipment provided by the embodiments of the present disclosure provides the following beneficial effects:

By providing a reaction chamber of the semiconductor processing equipment primarily consisting of a process tube, a sealing flange, and a sealing ring, after assembly, the sealing flange and the process tube are fixedly positioned relative to each other, and the sealing ring is pressed between the sealing flange and the annular protrusion of the process tube. This allows process gas at the opening to be blocked by the sealing ring when it moves between the sealing flange and the annular protrusion, thereby achieving a seal. Furthermore, by positioning the sealing ring at the end of the process tube, the sealing ring is positioned away from the tube wall, that is, away from heat concentration areas of the process tube. This prevents direct contact between the sealing ring and the tube wall, thereby reducing damage to the sealing ring caused by direct heat conduction and extending its service life. Furthermore, the stress conditions of the sealing ring are improved, ensuring that the sealing ring is only subjected to compression forces from the annular protrusion and the sealing flange on its two sides, rather than from the tube wall, thereby reducing compression damage to the sealing ring.

Furthermore, the annular protrusion formed at the opening of the process tube eliminates the need to insert a sealing flange into the process tube during assembly of the semiconductor processing equipment's reaction chamber. This not only reduces assembly difficulty but also reduces scratches and damage to the outer wall of the process tube caused by inserting the sealing flange.

A second objective of the present disclosure is to provide semiconductor processing equipment that addresses the technical problem of easily damaged sealing rings in existing reaction chamber sealing structures.

The semiconductor processing equipment provided herein includes a frame and the reaction chamber of the semiconductor processing equipment described above, the reaction chamber of the semiconductor processing equipment being fixedly connected to the frame.

The semiconductor processing equipment of the present disclosure provides the following beneficial effects:

By incorporating the reaction chamber of the semiconductor processing equipment described above into the semiconductor processing equipment, the semiconductor processing equipment accordingly possesses all the advantages of the reaction chamber of the aforementioned semiconductor processing equipment, which will not be elaborated upon here.

### BRIEF DESCRIPTION OF THE DRAWINGS

To more clearly illustrate the technical solutions in the embodiments of the present disclosure or related technologies, the following briefly describes the drawings required for use in the description of the embodiments or related technologies. Obviously, the drawings described below represent only the embodiments of the present disclosure. Persons skilled in the art can, without inventive effort, derive other drawings from the provided drawings.
FIG. 1 is a cross-sectional view of the structure of a reaction chamber of a semiconductor processing equipment provided in an embodiment of the present disclosure;
FIG. 2 is an enlarged view of the partial structure at point A in FIG. 1;
FIG. 3 is an enlarged view of the partial structure in FIG. 2.

### DETAILED DESCRIPTION

To make the above-mentioned objectives, features, and advantages of the present disclosure more readily apparent, specific embodiments of the present disclosure are described in detail below with reference to the accompanying drawings. It should be understood that the specific embodiments described herein are intended solely to illustrate the present disclosure and are not intended to limit the present disclosure.

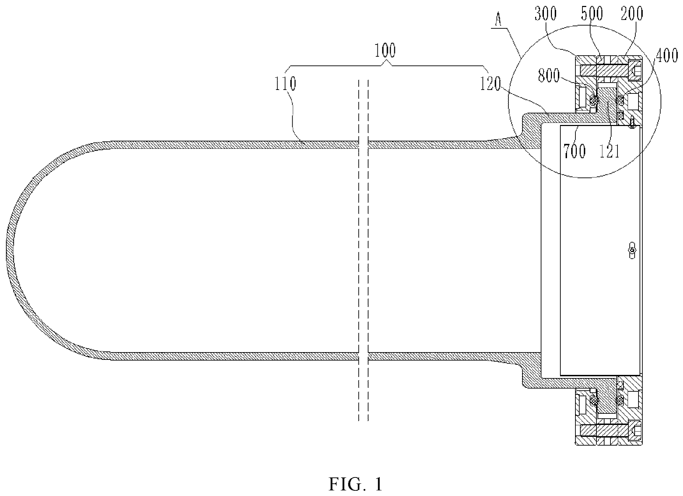

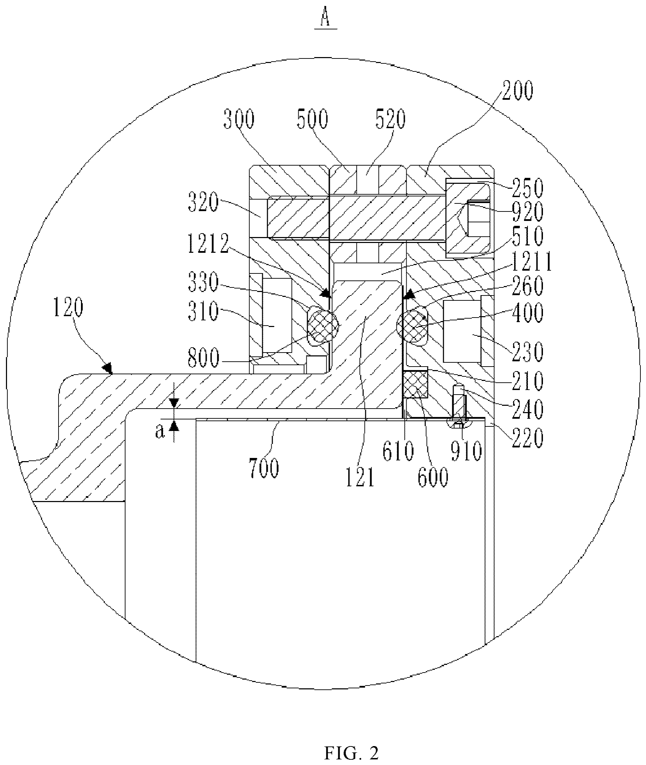

FIG. 1 is a cross-sectional view of the structure of a reaction chamber of a semiconductor processing equipment provided in this embodiment, and FIG. 2 is an enlarged view of the partial structure at point A in FIG. 1. As shown in FIGs. 1 and 2, this embodiment provides a reaction chamber of a semiconductor processing equipment, including a process tube 100, a sealing flange 200, and a sealing ring 400. Specifically, an annular flange 121 is provided on the outer wall of the process tube 100. This annular flange 121 is located at the end of the outer wall of the process tube 100 near the opening of the process tube 100. That is, the annular flange 121 is located at the end of the process tube 100, where the process tube 100 has an opening. In some examples, the surface of the annular flange 121 near the opening of the process tube 100 is coplanar with the radial plane of the opening. That is, the rightward end surface of the annular flange 121 in FIG. 1 is flush with the radial plane of the opening. A sealing flange 200 is disposed on the side of the annular flange 121 near the opening. A sealing ring 400 surrounds the opening and is pressed between the sealing flange 200 and the annular flange 121. The sealing flange 200 and the process tube 100 are fixedly disposed relative to each other.

By setting up a reaction chamber of a semiconductor processing equipment mainly composed of a process tube 100, a sealing flange 200 and a sealing ring 400, after assembly is completed, the sealing flange 200 and the process tube 100 are relatively fixedly arranged, and the sealing ring 400 is pressed between the sealing flange 200 and the annular flange 121 arranged on the outer wall of the process tube 100, so that the process gas around the opening is blocked by the sealing ring 400 when moving between the sealing flange 200 and the annular flange 121to achieve the sealing purpose. Among them, by locating the annular flange 121 at the end of the outer wall of the process tube 100 close to the opening of the process tube 100, that is, arranging the sealing ring 400 at the end of the process tube 100, the sealing ring 400 is kept away from the tube wall of the process tube 100, that is, the sealing ring 400 is kept away from the heat concentration area of the process tube 100. On the one hand, it can prevent the sealing ring 400 from direct contact with the tube wall of the process tube 100, thereby reducing the damage to the sealing ring 400 caused by direct heat conduction, thereby achieving the purpose of extending the service life of the sealing ring 400. On the other hand, it can also improve the stress condition of the sealing ring 400, so that the sealing ring 400 is only subjected to the extrusion force from the annular flange 121 and the sealing flange 200 on its two sides, and is not subjected to the extrusion force from the tube wall, thereby reducing the extrusion damage to the sealing ring 400. Furthermore, by making the surface of the annular flange 121 close to the opening of the process tube 100 coplanar with the radial plane where the opening is located, the annular flange 121 can be located at the position farthest from the tube wall of the process tube 100, thereby making the sealing ring 400 away from the tube wall of the process tube 100 to the greatest extent.

Furthermore, by positioning the annular flange 121 on the outer wall of the process tube 100 near the end of the opening, for example, by forming the annular flange 121 at the opening of the process tube 100, the sealing flange 200 need not be inserted into the process tube 100 during assembly of the reaction chamber of the semiconductor processing equipment. This not only reduces assembly difficulty but also reduces scratches and damage to the outer wall of the process tube 100 caused by inserting the sealing flange 200.

In this embodiment, the process tube 100 is made of, for example, quartz.

Continuing with FIG. 2, in this embodiment, the annular flange 121 has a first surface 1211 and a second surface 1212 that are opposite to each other. The surface of the annular flange 121 that is closest to the opening of the process tube 100 is the first surface 1211, that is, the right side surface of the annular flange 121 from the perspective of FIG. 2 is the first surface 1211, while the second surface 1212 is the left side surface of the annular flange 121 from the perspective of FIG. 2. Specifically, the sealing flange 200 is disposed on the first surface 1211 of the annular flange 121, and the sealing ring 400 is pressed between the sealing flange 200 and the first surface 1211.

Continuing with FIGs. 1 and 2, in this embodiment, the reaction chamber of the semiconductor processing equipment may further include a fixed flange 300 and a limiting support 500. Specifically, the fixed flange 300 is mounted on the process tube 100 and is located on the side of the annular flange 121 facing away from the opening. In other words, the fixed flange 300 is disposed on the second surface 1212 of the annular flange 121. The fixed flange 300 is configured to be fixedly connected to a frame (not shown) of the semiconductor processing equipment to support the process tube 100. The sealing flange 200 is fixedly connected to the fixed flange 300. The limiting support 500 is located between the sealing flange 200 and the fixed flange 300 to maintain a set distance between the sealing flange 200 and the fixed flange 300. The set distance is greater than the thickness of the annular flange 121.

When the reaction chamber of the semiconductor processing equipment is working, the fixed flange 300 is fixedly connected to the frame of the semiconductor processing equipment, supporting the process tube 100; the sealing flange 200 and the fixed flange 300 are respectively arranged on both sides of the annular flange 121, and the limiting support 500 is located between the sealing flange 200 and the fixed flange 300, and serves as a limiting support for the sealing flange 200 and the fixed flange 300, so that the sealing flange 200 and the fixed flange 300 are always separated by a set distance greater than the thickness of the annular flange 121, preventing the sealing flange 200 and the fixed flange 300 from shifting and colliding with the annular flange 121 when the sealing flange 200 and the fixed flange 300 are fixedly connected and thereby damaging the process tube 100, to provide good protection for the process tube 100.

Preferably, in this embodiment, the limiting support 500 is annular and is disposed around the annular flange 121, specifically surrounding the outer wall of the process tube 100 near the end of the opening of the process tube 100, and located on the outer circumference of the annular flange 121.

By providing the limiting support 500 with an annular shape, the limiting support 500 provides positional support between the sealing flange 200 and the fixed flange 300 at all locations along the circumference of the process tube 100. This arrangement ensures that the sealing flange 200 and the fixed flange 300 are uniformly stressed along the circumference when they are fixedly connected, preventing structural deformation caused by uneven localized stress.

Please refer to FIG. 2, in this embodiment, the inner surface of the limiting support 500 and the outer surface of the annular flange 121 are spaced apart to form a heat dissipation channel 510, and the limiting support 500 is provided with heat dissipation holes 520, where the heat dissipation holes 520 connect the heat dissipation channel 510 with the external environment.

During operation of the reaction chamber of this semiconductor processing equipment, heat transferred to the sealing ring 400 enters the heat dissipation channel 510 through the gap between the annular flange 121 and the sealing flange 200. Alternatively, heat transferred to the sealing ring 400 enters the heat dissipation channel 510 through the sealing flange 200 in contact thereof. Due to the connection between the heat dissipation channel 510 and the heat dissipation holes 520, the heat entering the heat dissipation channel 510 is discharged to the external environment through the heat dissipation holes 520, achieving heat dissipation.

This arrangement effectively transfers heat received by the sealing ring 400 to the external environment. By "air cooling" the sealing ring 400, the heat accumulation in the sealing ring 400 is reduced, thereby further extending the service life of the sealing ring 400.

In this embodiment, the axis of the heat dissipation hole 520 is aligned with the radial direction of the process tube 100. This arrangement shortens the airflow path between the heat dissipation channel 510 and the external environment, thereby achieving rapid heat dissipation.

In this embodiment, the number of heat dissipation holes 520 can be multiple, and the multiple heat dissipation holes 520 are dispersedly arranged along the circumference of the limiting support 500. This arrangement can not only increase the number of heat dissipation holes 520, but also increase the distribution area of the heat dissipation holes 520, thereby improving heat dissipation efficiency and heat dissipation uniformity, and preventing the occurrence of local heat concentration on the sealing ring 400.

Continuing with FIG. 2, in this embodiment, the sealing flange 200 and the fixed flange 300 are connected via fixing bolts 920. Specifically, the sealing flange 200 defines a fixed through-hole 250, the fixed flange 300 defines a fixing screw hole 320, and the limiting support 500 defines a relief through-hole. The fixed through-hole 250, the relief through-hole, and the fixing screw hole 320 are aligned. The fixing bolt 920 passes through the fixed through-hole 250 and the relief through-hole in sequence and screws into the fixing screw hole 320. Thus, the fixing bolt 920 is threaded with the fixing screw hole 320 for connection, thereby achieving an assembled connection between the sealing flange 200 and the fixed flange 300.

In other embodiments, the limiting support 500 can also be configured as a plurality of independent support members distributed along the circumference of the process tube 100. These can similarly provide a limiting support function between the sealing flange 200 and the fixed flange 300. Furthermore, the space between any two adjacent support members can be used to form a heat dissipation space, similar to the heat dissipation holes 520 described above.

Preferably, in this embodiment, the material of the limiting support 500 is, for example, aluminum. This material form of the limiting support 500 can, on the one hand, improve the thermal conductivity of the limiting support 500, thereby further improving the heat dissipation efficiency, and on the other hand, can also reduce the weight of the limiting support 500 to a certain extent.

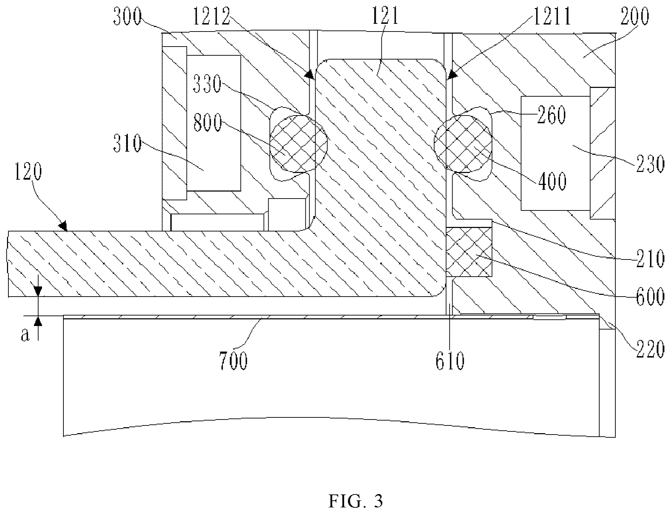

FIG. 3 is an enlarged view of the partial structure in FIG. 2. Continuing with FIG. 2 and in conjunction with FIG. 3, in this embodiment, the reaction chamber may further include a buffering gasket 600, where the buffering gasket 600 is located between the sealing flange 200 and the annular flange 121, and is used to create a buffering gap 610 between the sealing flange 200 and the annular flange 121. Specifically, the buffering gasket 600 is located between the sealing flange 200 and the first surface 1211 of the annular flange 121, and is used to create a buffering gap 610 between the sealing flange 200 and the first surface 1211 of the annular flange 121.

By providing a buffering gap 610 between the sealing flange 200 and the first surface 1211, the buffering gasket 600 ensures that even if the sealing ring 400 is compressed excessively, causing the process tube 100 and the sealing flange 200 to move axially toward each other, the annular flange 121 of the process tube 100 will first contact the buffering gasket 600 rather than directly colliding with the sealing flange 200. This provides further support and cushioning between the sealing flange 200 and the annular flange 121, creating a "double insurance" between the sealing flange 200 and the annular flange 121 and providing dual protection for the process tube 100.

In this embodiment, the buffering gasket 600 can be made of polytetrafluoroethylene. This arrangement minimizes compression of the buffering gasket 600, effectively providing a buffering effect between the sealing flange 200 and the annular flange 121.

In this embodiment, one end of the buffering gasket 600 abuts against the first surface 1211 of the annular flange 121, and the other end of the buffering gasket 600 abuts against the sealing flange 200.

Continuing with FIGs. 2 and 3, in this embodiment, the buffering gasket 600 is located closer to the axis of the process tube 100 than the sealing ring 400 along the radial direction of the process tube 100.

This arrangement effectively blocks heat transfer to the sealing ring 400 through the buffering gasket 600, reduces heat transfer to the sealing ring 400 and provides a certain degree of thermal insulation. Furthermore, this arrangement of the buffering gasket 600 provides a secondary seal between the annular flange 121 and the sealing flange 200, enhancing the sealing effect.

Continuing with FIGs. 2 and 3, in this embodiment, the surface of the sealing flange 200 facing the first surface 1211 is provided with a mounting groove 210, which receives the buffering gasket 600.

By providing a mounting groove 210 for accommodating the buffering gasket 600 on the sealing flange 200, on the one hand, the buffering gasket 600 can be reliably installed to prevent the buffering gasket 600 from shifting or falling off. On the other hand, the buffering gasket 600 can be detachably connected to the sealing flange 200, which facilitates maintenance or replacement of the buffering gasket 600.

Continuing with FIGs. 2 and 3, in this embodiment, the reaction chamber further includes a reflective screen 700. The reflective screen 700 surrounds the inner circumference (for example, inner wall) of the process tube 100. Its orthographic projection on the inner circumference of the process tube 100 covers the area where the sealing ring 400 is located. That is, along a direction parallel to the axial direction of the process tube 100, the reflective screen 700 completely covers the area where the sealing ring 400 is located. The reflective screen 700 reflects thermal radiation within the reaction chamber of the semiconductor processing equipment. By completely covering the area where the sealing ring 400 is located, the reflective screen 700 provides a strong reflective effect, thereby reducing the intensity of thermal radiation received by the sealing ring 400. This effectively mitigates the adverse effects of thermal radiation on the sealing ring 400 and further extends the service life of the sealing ring 400.

In this embodiment, to achieve this reflective effect, the reflective screen 700 is made of, for example, bright stainless steel.

In this embodiment, the sealing flange 200 is provided with an annular step 220, which is arranged around the axis of the process tube 100 and protrudes from the inner surface of the sealing flange 200 in the radial direction of the process tube 100. One end of the reflective screen 700 is embedded in the process tube 100, and the other end of the reflective screen 700 abuts the annular step 220. Specifically, in this embodiment, the reflective screen 700 has a cylindrical structure, and the two ends of the cylindrical structure along the axial direction constitute the two ends of the reflective screen 700. The right end of the reflective screen 700 abuts the annular step 220, and the left end of the reflective screen 700 remains open.

The above arrangement creates a sealed area enclosed by the outer circumference of the reflective screen 700, the inner circumference of the process tube 100, the annular step 220, and the sealing ring 400. This creates a partially sealed area within the reaction chamber. Once heat enters this area, it cannot escape through the end (right end) of the reflective screen 700. This effectively creates a "vacuum seal" within the reaction chamber, preventing heat generated within the reaction chamber from re-entering. This effectively prevents convection and prevents the continuous input of heat from acting on the sealing ring 400, and further minimizes the thermal impact on the sealing ring 400.

Referring to FIGs. 2 and 3, in this embodiment, the annular step 220 is integrally formed with the flange body of the sealing flange 200. This arrangement not only increases the structural strength of the connection between the annular step 220 and the flange body, but also reduces the number of components and simplifies the assembly process.

Referring to FIGs. 2 and 3, in this embodiment, the annular step 220 is formed only within the inner space of the sealing flange 200. This arrangement can reduce the space occupied by the annular step 220 on the end side of the sealing flange 200.

Continuing with FIGs. 2 and 3, in this embodiment, the distance between the outer circumference of the reflective screen 700 and the inner circumference of the process tube 100 is a, where 2 mm≤a≤3 mm.

By limiting the distance between the outer circumference of the reflective screen 700 and the inner circumference of the process tube 100 to this range, it is possible to prevent the reflective screen 700 from linearly expanding and being crushed by heat due to a too small distance between the outer circumference of the reflective screen 700 and the inner circumference of the process tube 100. It is also possible to prevent the reflective screen 700 from being excessively heated due to excessive heat ingress, thereby shortening the service life of the sealing ring 400.

Continuing with FIGs. 2 and 3, in this embodiment, the reflective screen 700 is mounted to the sealing flange 200 via connecting bolts 910. Specifically, the sealing flange 200 is provided with a connecting screw hole 240, the hole axis of the connecting screw hole 240 is along the radial direction of the sealing flange 200, and the connecting bolt 910 passes through the reflective screen 700 and is screwed into the above-mentioned connecting screw hole 240, that is, the connecting bolt 910 is threaded with the connecting screw hole 240 for connection, thereby realizing the installation and fixation of the reflective screen 700 on the sealing flange 200.

Continuing with FIGs. 2 and 3, in this embodiment, the sealing flange 200 is provided with a first flow channel 230. Specifically, the first flow channel 230 is arranged around the axis of the process tube 100. The first flow channel 230 is used to flow a cooling fluid. By providing the first flow channel 230 in the sealing flange 200, the sealing ring 400 can be cooled, thereby rapidly reducing the temperature of the sealing ring 400.

Furthermore, in some embodiments, the sealing ring 400 and the first flow channel 230 are positioned opposite to each other in a direction parallel to the axial direction of the process tube 100. This shortens the distance between the sealing ring 400 and the first flow channel 230, thereby enhancing the cooling effect on the sealing ring 400 and rapidly reducing the temperature of the sealing ring 400.

In this embodiment, the cooling fluid flowing in the first flow channel 230 is a coolant, which may be water. In other embodiments, the cooling fluid flowing in the first flow channel 230 may also be cooling gas.

Continuing with FIGs. 2 and 3, in this embodiment, the surface of the sealing flange 200 facing the annular flange 121 defines a first dovetail groove 260, into which the sealing ring 400 is received. This arrangement facilitates the installation and secures the sealing ring 400. Specifically, after assembly, the sealing ring 400 securely fits one side against the bottom surface of the first dovetail groove 260, while the other side securely fits against the first surface 1211 of the annular flange 121. The bottom surface of the first dovetail groove 260 corresponds to the right surface of the first dovetail groove 260 as viewed in FIG. 2.

In this embodiment, the sealing flange 200 can be made of stainless steel.

Continuing with FIGs. 2 and 3, in this embodiment, the reaction chamber may further include a buffering ring 800. The buffering ring 800 surrounds the process tube 100 and is pressed between the fixed flange 300 and the annular flange 121. Specifically, the buffering ring 800 is pressed between the fixed flange 300 and the second surface 1212 of the annular flange 121.

By placing the buffering ring 800 between the fixed flange 300 and the second surface 1212 of the annular flange 121, a buffering effect is provided on the side of the annular flange 121 facing the fixed flange 300. Specifically, the second surface 1212 of the annular flange 121 acts as a buffer, preventing direct contact between the annular flange 121 and the fixed flange 300, which could cause damage.

With further reference to FIGs. 2 and 3, in this embodiment, the fixed flange 300 is provided with a second flow channel 310. Specifically, the second flow channel 310 is provided around the axis of the process tube 100. The second flow channel 310 is also used to flow the cooling fluid. By providing the second flow channel 310 on the fixed flange 300, the buffering ring 800 can be cooled, thereby quickly reducing the temperature of the buffering ring 800 and extending the service life of the buffering ring 800.

Furthermore, in some embodiments, the buffering ring 800 and the second flow channel 310 are positioned parallel to the axial direction of the process tube 100. This shortens the distance between the buffering ring 800 and the second flow channel 310, thereby enhancing the cooling effect on the buffering ring 800, quickly reducing the temperature of the buffering ring 800 and extending the service life of the buffering ring 800.

In this embodiment, the cooling fluid flowing in the second flow channel 310 is a coolant, which may be water. In other embodiments, the cooling fluid flowing in the second flow channel 310 may also be cooling gas.

Referring again to FIGs. 2 and 3, in this embodiment, the surface of the fixed flange 300 facing the annular flange 121 is provided with a second dovetail groove 330, in which the buffering ring 800 is received. This arrangement facilitates the installation and securement of the buffering ring 800. Specifically, after assembly, the buffering ring 800 has one side tightly aligned with the bottom surface of the second dovetail groove 330 and the other side tightly aligned with the second surface 1212 of the annular flange 121. The bottom surface of the second dovetail groove 330 is the left surface of the second dovetail groove 330 as viewed in FIG. 2.

In this embodiment, the fixed flange 300 can be made of stainless steel.

In this embodiment, both the sealing ring 400 and the buffering ring 800 can be O-rings. The sealing ring 400 can be made of fluororubber, and the buffering ring 800 can also be made of fluororubber.

Continuing with FIG. 1, in this embodiment, the process tube 100 includes a body section 110 and an opening section 120 arranged along its axial direction. The opening section 120 is made of a non-transparent material. By making the opening section 120 of the process tube 100 non-transparent, the light transmittance of the opening section 120 is effectively reduced, thereby reducing the heat radiation effect on the sealing ring 400 and further minimizing the thermal impact on the sealing ring 400.

In this embodiment, the opening section 120 is made of opaque milky quartz.

In some embodiments, the outer wall of the process tube 100 partially extends away from its axis to form an annular flange 121. For example, when the process tube 100 includes the body section 110 and the opening section 120, the outer wall of the opening section 120 partially extends away from its axis to form the annular flange 121. Furthermore, in this embodiment, the opening section 120 can be connected to the body section 110 by welding; the annular flange 121 is integrally formed in the opening section 120.

In addition, this embodiment further provides a semiconductor processing equipment, including a frame and a reaction chamber of the semiconductor processing equipment, where the reaction chamber of the semiconductor processing equipment is fixedly connected to the frame. Specifically, the reaction chamber of the semiconductor processing equipment is fixedly connected to the frame via a fixed flange 300.

By installing the above-described reaction chamber of the semiconductor processing equipment in a semiconductor processing equipment, the semiconductor processing equipment accordingly possesses all the advantages of the reaction chamber of the above-described semiconductor processing equipment, which will not be elaborated here.

Although the present disclosure is disclosed above, the present disclosure is not limited thereto. Any person skilled in the art may make various changes and modifications without departing from the spirit and scope of the present disclosure. Therefore, the scope of protection of the present disclosure should be determined by the scope defined by the claims.

Finally, it should be noted that, in this document, relational terms such as first and second, etc., are merely used to distinguish one entity or operation from another entity or operation, and do not necessarily require or imply any actual relationship or order between these entities or operations. Furthermore, the term "comprise" or any other variation thereof is intended to cover non-exclusive inclusion, such that a process, method, article, or device comprising a list of elements includes not only those elements but also other elements not expressly listed, or elements inherent to such process, method, article, or apparatus. Without further limitation, the phrase "comprising a..." does not preclude the presence of additional identical elements in the process, method, article, or device comprising the recited elements.

In the above embodiments, the descriptions of directions such as "inside," "outside," "left," and "right" are all based on the drawings.

The above description of the disclosed embodiments is intended to enable one skilled in the art to implement or use the present disclosure. Various modifications to these embodiments will be readily apparent to one skilled in the art, and the general principles defined herein may be implemented in other embodiments without departing from the spirit or scope of the present disclosure. Therefore, the present disclosure is not limited to the embodiments shown herein, but is intended to be construed in the widest manner consistent with the principles and novel features disclosed herein.

## Claims

1. A reaction chamber of semiconductor processing equipment, comprising a process tube, a sealing flange, and a sealing ring;
an outer wall of the process tube is provided with an annular protrusion, the annular protrusion being located at an end of the outer wall near an opening of the process tube, the sealing flange being provided on a side of the annular protrusion near the opening, the sealing ring surrounding the opening and being pressed between the sealing flange and the annular protrusion; the sealing flange and the process tube being fixedly disposed relative to each other.

2. The reaction chamber of semiconductor processing equipment according to claim 1, further comprising a fixed flange and a limiting support, the fixed flange being fitted over the process tube and located on a side of the annular protrusion facing away from the opening, the fixed flange being fixedly connected to a frame of the semiconductor processing equipment; the sealing flange being fixedly connected to the fixed flange; and the limiting support being located between the sealing flange and the fixed flange and used to space apart the sealing flange and the fixed flange by a set distance, the set distance being greater than a thickness of the annular protrusion.

3. The reaction chamber of semiconductor processing equipment according to claim 2, wherein the limiting support is annular and is disposed around the annular protrusion.

4. The reaction chamber of semiconductor processing equipment according to claim 3, wherein an inner surface of the limiting support and an outer surface of the annular protrusion are spaced apart to form a heat dissipation channel, and the limiting support is provided with heat dissipation holes, which connect the heat dissipation channel to an external environment.

5. The reaction chamber of semiconductor processing equipment according to claim 1, further comprising a buffering gasket located between the sealing flange and the annular protrusion to provide a buffering gap between the sealing flange and the annular protrusion.

6. The reaction chamber of semiconductor processing equipment according to claim 5, wherein, along a radial direction of the process tube, the buffering gasket is closer to an axis of the process tube than the sealing ring.

7. The reaction chamber of semiconductor processing equipment according to claim 1, further comprising a reflective screen disposed around an inner circumference of the process tube, such that its orthographic projection on the inner circumference of the process tube covers an area where the sealing ring is located.

8. The reaction chamber of semiconductor processing equipment according to claim 7, wherein the sealing flange is provided with an annular step, the annular step being arranged around an axis of the process tube and projecting radially from an inner surface of the sealing flange;
one end of the reflective screen is embedded in the process tube, and the other end of the reflective screen abuts the annular step.

9. The reaction chamber of semiconductor processing equipment according to claim 7 or 8, wherein a distance between an outer circumference of the reflective screen and the inner circumference of the process tube is a, where 2 mm≤a≤3 mm.

10. The reaction chamber of semiconductor processing equipment according to claim 1, wherein the sealing flange is provided with a first flow channel, the first flow channel being arranged around an axis of the process tube, and the first flow channel is used to flow a cooling fluid.

11. The reaction chamber of semiconductor processing equipment according to claim 2, further comprising a buffering ring, the buffering ring surrounding the process tube and pressed between the fixed flange and the annular protrusion.

12. The reaction chamber of semiconductor processing equipment according to claim 11, wherein the fixed flange is provided with a second flow channel, the second flow channel being arranged around the axis of the process tube, the second flow channel being used to flow a cooling fluid.

13. The reaction chamber of semiconductor processing equipment according to claim 1, wherein the process tube comprises a body section and an opening section arranged axially along the process tube, wherein the opening section is made of a non-transparent material, and the annular protrusion is located at an end of the opening section near the opening.

14. The reaction chamber of semiconductor processing equipment according to claim 1 or 13, wherein an outer wall of the process tube partially extends away from its axis to form the annular protrusion.

15. A semiconductor processing equipment, comprising a frame and the reaction chamber of semiconductor processing equipment according to any one of claims 1-14, the reaction chamber of the semiconductor processing equipment being fixedly connected to the frame.
